# EUROPÄISCHE PATENTSCHRIFT

(11) **EP 0 392 035 B1**
(45) Veröffentlichungstag und Bekanntmachung des Hinweises auf die Patenterteilung: **22.06.1994**
(21) Anmeldenummer: 89106360.4
(22) Anmeldetag: 11.04.1989
(51) Int. Cl.: G01R 31/28

(54) **Verfahren zur Aufzeichnung oder Abbildung zeitabhängiger Potentiale in Bauelementen der Mikroelektronik**
Method for recording and mapping of time dependent potentials in microelectronic devices
Procédé pour l'enregistrement ou la visualisation de potentiels dépendants du temps dans des éléments de microélectronique

(43) Veröffentlichungstag der Anmeldung: 17.10.1990
(73) Patentinhaber: ICT Integrated Circuit Testing Gesellschaft für Halbleiterprüftechnik mbH, D-85551 Kirchheim (DE)
(72) Erfinder: Otto, Johann, Dipl.-Ing.(FH), D-8170 Bad Tölz (DE)
(74) Vertreter: Tetzner, Volkmar, Dr.-Ing. Dr. jur.

(56) Entgegenhaltungen:
- EP-A- 0 048 858
- EP-A- 0 062 097
- EP-A- 0 177 717
- EP-A- 0 225 969
- Proceedings of the XI th Internat.Congr.on Electron Microscopy vol. 1, 1986, Kyoto,J Seiten 621 - 622; H.Todokoro et.al.: "Electron beam tester with new timing control system and improved voltage analyser"

## Beschreibung

Die Erfindung bezieht sich auf ein Verfahren zur Aufzeichnung oder Abbildung eines periodischen Potentials nach dem Oberbegriff des Patentanspruchs 1.

Ein solches Verfahren ist aus Microelectronic Engineering Vol. 4 (1986) S. 77 - 106 und Scanning Vol. 5 (1983), S. 14 -24 bekannt.

Um Meßfehler bei der Aufzeichnung zeitabhängiger elektrischer Signale im Innern mikroelektronischer Bauelemente zu vermeiden, ist es notwendig, die das Potential abtastende Elektronensonde während der gesamten Meßzeit sicher auf der interessierenden Leiterbahn zu positionieren. Dies stellt höchste Anforderungen an die Qualität und Stabilität des die Sonde erzeugenden Elektronenstrahlmeßgeräts, insbesondere wenn Messungen in modernen Speicherbausteinen (Leiterbahnbreite d < 1,5 »m) durchzuführen sind. Besondere Probleme bereiten hier
- thermische und mechanische Verschiebungen der den IC aufnehmenden Trägervorrichtung,
- Ablenkungen der Elektronensonde infolge elektrischer oder magnetischer Störfelder in der Nähe von Bonddrähten oder internen Stromschleifen und
- Instabilitäten des Elektronenstrahls.

All diese Effekte bewirken eine Versetzung der Elektronensonde auf dem Bauelement, wodurch sich die Meßstelle von der Mitte der Leiterbahn zu deren Rand hin verschiebt. Hier sind die durch den Topographie- bzw. Materialkontrast sowie den sogenannten Lokal-Field-Effekt bedingten Störeinflüsse allerdings nicht mehr zu vernachlässigen, so daß unter Umständen erhebliche Meßfehler auftreten.

Die EP-A-0 225 969 beschreibt ein Verfahren zur genauen Positionierung einer Elektronensonde auf der Leiterbahn eines Bauelements der Mikroelektronik. Mit diesem verfahren läßt sich eine beispielsweise durch die Aufladung elektronenoptischer Komponenten oder der Probenoberfläche hervorgerufene Drift der Elektronensonde feststellen und kompensieren. Eine Abweichung der tatsächlichen Sondenposition von der gewünschten Sollposition wird hierbei durch den Vergleich eines digitalisierten Sekundärelektronenbildes der Meßstellenumgebung mit einem vorab aufgezeichneten und ebenfalls in digitalisierter Form vorliegenden Referenzbild erkannt. Als Ergebnis dieses Vergleichs liefert eine Rechnereinheit Korrektursignale, die man den im Ablenksystem des Elektronenstrahlgeräts fließenden Strömen als Offset überlagert.

Erschwert wird die Messung elektrischer Potentiale an Leiterbahnen hochintegrierter Schaltungen auch durch das sogenannte "Strahlverreißen". Hierbei handelt es sich um kurzzeitige Versetzungen der Elektronensonde, die insbesondere mit dem Bausteintakt korreliert sind. Kurzzeitige Strahlversetzungen lassen sich mit dem bekannten Verfahren aber nicht erkennen und korrigieren, da man bei der Bestimmung der Korrektursignale ausschließlich topografische Parameter berücksichtigt.

Der Erfindung liegt die Aufgabe zugrunde, ein Verfahren der eingangs genannten Art anzugeben, bei dem insbesondere die durch kurzzeitige Versetzungen der Elektronensonde hervorgerufenen Meßfehler weitgehend vermieden werden. Diese Aufgabe wird erfindungsgemäß durch ein Verfahren nach Patentanspruch 1 gelöst.

Der mit der Erfindung erzielbare Vorteil besteht insbesondere darin, daß Potentialmessungen an Submikrometerstrukturen mit hoher Genauigkeit durchgeführt werden können.

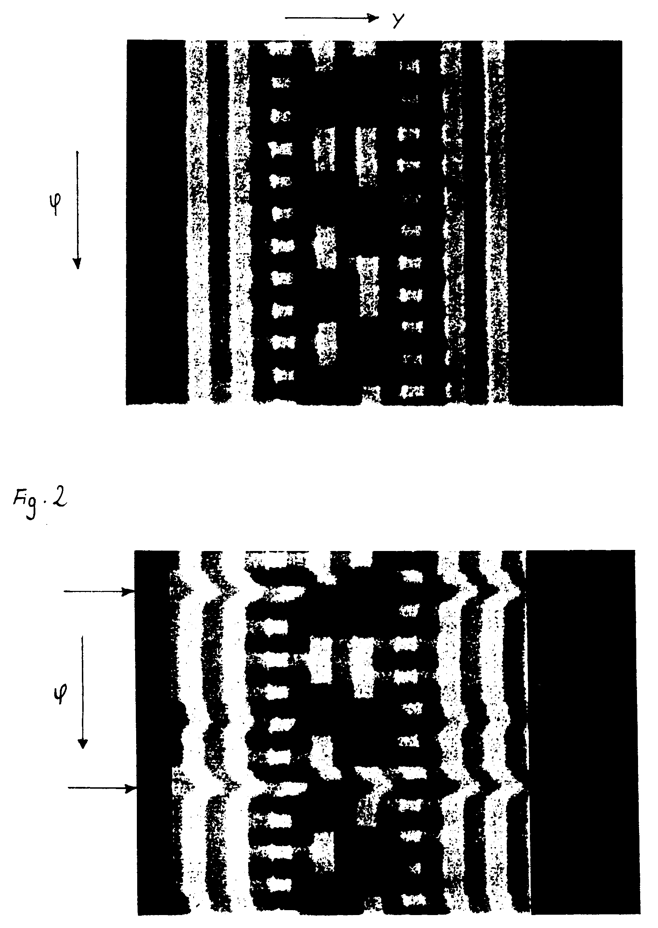

Die abhängigen Ansprüche betreffen vorteilhafte Ausgestaltungen und Weiterbildungen der im folgenden anhand der Zeichnung näher erläuterten Erfindung. Hierbei zeigen die Figuren 1 und 2 Potentialkontrastbilder einer Busstruktur in einem Speicherbaustein.

Die Fig. 1 zeigt das sogenannte Logikbild einer Busstruktur in einem 4 M-Speicherbaustein. Zur Erzeugung dieses Bildes wird die Elektronensonde zeilenweise über den Speicherbaustein geführt, wobei die Ablenkrichtung senkrecht zu den nur etwa 1,1 »m breiten Leiterbahnen orientiert ist. Da man die Phasenlage der synchron mit dem Bausteintakt eingetasteten Elektronenimpulse nach jedem Zeilendurchlauf um einen vorgegebenen Betrag ändert, erhält man auf dem Monitor ein Potentialkontrastbild der Busstruktur, in dem das den Leiterbahnen überlagerte Balkenmuster die Zeitabhängigkeit bzw. Phase φ des jeweils anliegenden Signals repräsentiert (s. Microelectronic Engineering, Vol. 4 (1986) S. 84/85; Scanning, Vol. 5 (1983) S. 17)

Die Fig. 2 zeigt das Logikbild derselben Busstruktur, wobei allerdings ein in unmittelbarer Nachbarschaft der Leiterbahnen vorhandener Bonddraht infolge der dynamischen Stromaufnahme des Speicherbausteins zeitabhängige, mit internen Signalen, also insbesondere dem Bausteintakt, korrelierte Störfelder erzeugt.

Da diese Störfelder eine phasenabhängige Ablenkung der Elektronensonde bewirken, entstehen im Logikbild Verzerrungen und Versetzungen, die sich periodisch und phasenstarr wiederholen (in Fig. 2 durch Pfeile angedeutet). Diese Versetzungen können unter Umständen so groß sein, daß keine eindeutige Zuordnung der durch das Balkenmuster repräsentierten Signale zu den jeweiligen Leiterbahnen mehr möglich ist.

Besondere Probleme bereiten Messungen der Zeitabhängigkeit des Potentials an einer der Leiterbahnen der Busstruktur (Waveform measurement: s. Microelectronic Engineering, Vol. 4, 1986, S. 84/85), wenn das Störfeld periodisch innerhalb des Meßfensters, d. h. innerhalb des abzutastenden Phasenbereichs auftritt. Die Elektronensonde wird dann unter Umständen so weit von der Leiterbahnmitte abgelenkt, daß anstelle des Leiterbahnsignals nur ein Untergrundsignal gemessen wird.

Um solche Fehlmessungen zu vermeiden, wird vorgeschlagen, die durch periodisch auftretende Störeffekte verursachten Versetzungen der Elektronensonde phasenabhängig zu bestimmen und während der Messung oder Abbildung der Potentiale durch eine der Versetzung entgegenwirkende Ablenkung der Elektronensonde zu kompensieren. Da die Versetzung der Elektronensonde auf dem Bauelement der Versetzung der Leiterbahnen in dem die Phase als Ordinate aufweisenden Logikbild entspricht, kann man die Abweichungen der Meßstelle von der Sollposition (Leiterbahnmitte) unmittelbar dem Monitorbild entnehmen und aufzeichnen. Es kommen hierbei die in modernen Elektronenstrahlmeßgeräten implementierten Verfahren der Bildverarbeitung zur Anwendung (beispielsweise Bestimmung der Koordinaten der Leiterbahnmitte mit Hilfe eines dem Logikbild überlagerten Fadenkreuzes). Die der Versetzung proportionalen, in einem Speicher abgelegten Korrekturwerte können dann während der Messungen phasenrichtig ausgelesen und den die Ablenkeinheit des Elektronenstrahlmeßgeräts ansteuerenden Signalen überlagert werden. Die Phasensteuerung übernimmt hierbei beispielsweise die in der Meßelektronik des Elektronenstrahlmeßgeräts üblicherweise vorhandene Boxcareinheit (s. beispielsweise US-A- 4,486,660 bzw. Scanning, Vol. 5, 1983, S. 18 - 20).

Steht kein Logikbild des untersuchten Baustelements zur Verfügung, müssen die Versetzungen der Elektronensonde vor jeder Potentialmessung für die zugehörige Phase bestimmt werden. Man kann sich hierbei des aus der US-A-4,705,954 bekannten Verfahrens der automatischen Leiterbahnmittensuche bedienen. Die Elektronensonde wird dabei zu einem durch die Phase φ definierten Zeitpunkt periodisch eingetastet und quer zu der das interessierende Signal führenden Leiterbahn abgelenkt. Gleichzeitig zeichnet man das in einem Detektor gemessene Sekundärelektronensignal ortsabhängig auf und bestimmt hieraus, beispielsweise durch Schwerpunktbildung, die der Versetzung der Elektronensonde proportionale Verschiebung der Leiterbahnmitte zu der gegebenen Phase. Diese Vorgehensweise hat den Vorteil, daß neben den durch Störfelder hervorgerufenen Versetzungen auch eine während der Messung auftretende mechanische oder thermische Drift kompensiert wird.

Die Erfindung ist selbstverständlich nicht auf die beschriebenen Ausführungsbeispiele beschränkt. So ist es ohne weiteres möglich, ein entzerrtes Logikbild zu erhalten, indem man die Versetzungen der Elektronensonde phasen- und ortsabhängig aus einem ohne Korrekturmaßnahmen gewonnenen Logikbild bestimmt und die Messung anschließend unter Berücksichtigung der Versetzungen nochmals durchführt.

Bei der Erzeugung des Logikbildes ist man nicht gezwungen, das Bauelement flächenhaft mit der Elektronensonde abzutasten. Wie in der US-A-4,471,302 beschrieben ist, wird die Ablenkung vorteilhafterweise entlang einer einzigen Abtastzeile vorgenommen.

Das erfindungsgemäße Verfahren eignet sich selbstverständlich zur Kompensation aller phasenstarr auftretenden Versetzungen der Elektronensonde, unabhängig davon, ob diese Versetzungen durch interne oder externe Störeffekte hervorgerufen werden.

## Patentansprüche

1. Verfahren zur Aufzeichnung oder Abbildung eines periodischen Potentials in einem Bauelement der Mikroelektronik, bei dem eine Teilchensonde auf einer Meßstelle positioniert oder über das Bauelement abgelenkt wird, bei dem die Teilchensonde synchron mit dem periodischen Potential eingetastet wird und bei dem die Phasenlage (φ) der Teilchenimpulse bezuglich des periodischen Potentials geändert und über einen definierten Phasenbereich geschoben wird,
**dadurch gekennzeichnet,**
daß Versetzungen der Teilchensonde in Bezug auf die Meßstelle abhängig von der Phasenlage (φ) bestimmt und während der Aufzeichnung oder Abbildung des periodischen Potentials phasenrichtig kompensiert werden.

2. Verfahren nach Anspruch 1,
**dadurch gekennzeichnet,** daß eine Versetzung durch eine der Versetzung entgegengerichtete Ablenkung der Teilchensonde kompensiert wird.

3. Verfahren nach Anspruch 1 oder 2,
**dadurch gekennzeichnet,** daß die Versetzungen in Abhängigkeit vom Ort der Teilchensonde auf dem Bauelement bestimmt werden.

4. Verfahren nach einem der Ansprüche 1 bis 3,
**dadurch gekennzeichnet,** daß die Versetzungen vor Beginn oder während der Aufzeichnung oder Abbildung des Potentials bestimmt und aufgezeichnet werden.

5. Verfahren nach einem der Ansprüche 1 bis 4,
**dadurch gekennzeichnet,**
daß die Teilchensonde periodisch senkrecht zu einer ein zeitabhängiges Signal führenden Leiterbahn abgelenkt wird, daß die Phasenlage der Teilchenimpulse nach einem Zeilendurchlauf um einen vorgegebenen Betrag verschoben wird, daß der Schreibstrahl eines Sichtgerätes synchron mit der Teilchensonde abgelenkt und dessen Intensität durch ein in einem Detektor gemessenes Sekundärteilchensignal moduliert wird und daß die phasenabhängige Versetzung der Teilchensonde auf dem Bauelement aus der Versetzung des Sekundärteilchenbildes der Leiterbahn bestimmt wird.

6. Verfahren nach Anspruch 5,
**dadurch gekennzeichnet,** daß die der Versetzung der Teilchensonde proportionale Verschiebung der Leiterbahnmitte bestimmt wird.

7. Verfahren nach einem der Ansprüche 1 bis 4,
**dadurch gekennzeichnet,** daß die Teilchensonde zu einem festen Zeitpunkt innerhalb der Periode des Potentials eingetastet wird, daß die Teilchensonde quer zu einer mit dem Potential beaufschlagten Leiterbahn abgelenkt wird, daß ein in einem Detektor gemessenes Sekundärteilchensignal ortsabhängig aufgezeichnet wird und daß aus dem Sekundärteilchensignal die Mitte der Leiterbahn und hieraus die Versetzung der Teilchensonde auf dem Bauelement bestimmt wird.

## Claims

1. Method for recording or imaging a periodic potential in a microelectronic component, in which a particle probe is positioned on a measuring point or is deflected over the component, in which the particle probe is gated in synchronism with the periodic potential, and in which the phase relation (φ) of the particle pulses is changed with respect to the periodic potential and is shifted over a defined phase range, characterized in that displacements of the particle probe with respect to the measuring point are determined as a function of the phase relation (φ) and are in-phase compensated during the recording or imaging of the periodic potential.

2. Method according to Claim 1, characterized in that a displacement is compensated by a deflection of the particle probe opposite to the direction of the displacement.

3. Method according to Claim 1 or 2, characterized in that the displacements are determined as a function of the location of the particle probe on the component.

4. Method according to one of Claims 1 to 3, characterized in that the displacements are determined and recorded before the beginning of or during the recording or imaging of the potential.

5. Method according to one of Claims 1 to 4, characterized in that the particle probe is periodically deflected perpendicular to an interconnect carrying a time-dependent signal, in that the phase relation of the particle pulses is shifted by a prescribed amount after a line pass, in that the write beam of a viewing device is deflected in synchronism with the particle probe and the intensity of the write beam is modulated by a secondary particle signal measured in a detector, and in that the phase-dependent displacement of the particle probe on the component is determined from the displacement of the secondary particle image of the interconnect.

6. Method according to Claim 5, characterized in that the displacement of the middle of the interconnect that is proportional to the displacement of the particle probe is determined.

7. Method according to one of Claims 1 to 4, characterized in that the particle probe is gated at a fixed point in time within the period of the potential, in that the particle probe is deflected transversely relative to an interconnect charged with the potential, in that a secondary particle signal measured in a detector is recorded in a location-dependent fashion, and in that the middle of the interconnect is determined from the secondary particle signal and the displacement of the particle probe on the component is determined from this.

## Revendications

1. Procédé pour enregistrer ou représenter un potentiel périodique d'un composant de la microélectronique, qui consiste à mettre une sonde de détection de particules en un emplacement de mesure ou à la déplacer au-dessus du composant, à règler la sonde de détection de particules en synchronisme avec le potentiel périodique et à modifier la position de phase (φ) des impulsions produites par les particules par rapport au potentiel périodique et à la déplacer dans un intervalle de phase défini, caractérisé en ce qu'il consiste à déterminer des décalages de la sonde de détection de particules par rapport à l'emplacement de mesure en fonction de la position de phase (φ) et à les compenser, d'une manière correcte en phase, pendant l'enregistrement ou la représentation du potentiel périodique.

2. Procédé suivant la revendication 1, caractérisé en ce qu'il consiste à compenser un décalage par un déplacement de la sonde de détection de particules, en sens opposé au décalage.

3. Procédé suivant la revendication 1 ou 2, caractérisé en ce qu'il consiste à déterminer les décalages en fonction de l'emplacement de la sonde de détection de particules sur le composant.

4. Procédé suivant l'une des revendications 1 à 3, caractérisé en ce qu'il consiste à déterminer et à enregistrer les décalages avant le début ou pendant l'enregistrement ou la représentation du potentiel.

5. Procédé suivant l'une des revendications 1 à 4, caractérisé en ce qu'il consiste à déplacer périodiquement la sonde de détection de particules perpendiculairement à une voie conductrice véhiculant un signal qui dépend du temps, à décaler la position de phase des impulsions produites par les particules d'une valeur prescrite après le parcours d'une ligne, à dévier le faisceau d'enregistrement d'un appareil de visualisation en synchronisme avec la sonde de détection de particules et à en moduler l'intensité par un signal produit par des particules secondaires et mesuré dans un détecteur, et à déterminer le décalage, qui dépend de la phase, de la sonde de détection de particules sur le composant à partir du décalage de l'image de la voie conductrice, qui est produite par les particules secondaires.

6. Procédé suivant la revendication 5, caractérisé en ce qu'il consiste à déterminer le déplacement du milieu de la voie conductrice, qui est proportionnel au décalage de la sonde de détection de particules.

7. Procédé suivant l'une des revendications 1 à 4, caractérisé en ce qu'il consiste à régler la sonde de détection de particules à un instant fixe dans la période du potentiel, à déplacer la sonde de détection de particules transversalement à une voie conductrice chargée par le potentiel, à enregistrer en fonction du lieu un signal produit par des particules secondaires et mesuré dans un détecteur et à déterminer le milieu de la voie conductrice à partir du signal produit par les particules secondaires et à en déterminer le décalage de la sonde de détection de particules sur le composant.
